**Europäisches Patentamt**

**European Patent Office**

**Office européen des brevets**

⑪ V(

**024**

⑫ EUROPÄISCHE PATEN

(45) Veröffentlichungstag der Patentschrift: **16.08.90**

(21) Anmeldenummer: **85112885.0**

(22) Anmeldetag: **11.10.85**

㊽ **Vorrichtung zur Vermeidung von lokalen Überhitzungen an**

(30) Priorität: **30.11.84 DE 3443702**

(43) Veröffentlichungstag der Anmeldung:
**04.06.86 Patentblatt 86/23**

(45) Bekanntmachung des Hinweises auf die
Patenterteilung:
**16.08.90 Patentblatt 90/33**

(84) Benannte Vertragsstaaten:
**AT BE CH DE FR GB IT LI LU NL SE**

(56) Entgegenhaltungen:
**EP-A-0 097 433**
**DE-A-2 937 218**
**FR-A-2 381 434**
**US-A-3 783 345**

**PATENT ABSTRACTS OF JAPAN, Band 6, Nr.**
**123 (E-117)1001r, 8. July 1982; & JP-A-57**
**50456 (NIPPON DENKI) 24.03.1982**

**PATENT ABSTRACTS OF JAPAN, Band 7, Nr. 99**
**(E-172)1244r, 2. August 1983; & JP-A-58 21359**
**(NIPPON DENKI) 08.02.1983**

㊼ Pa
W
D-

(72) Er.
Fri
D-
Er'
Ha
D-

t

Courier Press, Leamington Sp

EP 0 183 024 B1

**Beschreibung**

Die Erfindung betrifft eine Vorrichtung zur Vermeidung von lokalen Überhitzungen an mit Strombegrenzungswiderständen versehenen, in Vergußmassen eingebetteten, eigensicheren Meßumformern mit Hilfe von Formkörpern aus einem gut wärmeleitenden Material.

In der chemischen Verfahrenstechnik ist es üblich, die gegen Störungen empfindlichen Signale von Meßwertgebern, wie z.B. Thermoelementen und Widerstandsthermometern, durch Meßumformer, auch Transmitter genannt, auf einen Signalpegel anzuheben, der nur eine geringe Störempfindlichkeit hat, so daß dieses Signal über große Entfernungen übertragen werden kann. So ist es zum Beispiel üblich, als zu übertragendes Signal einen durch den Meßumformer je nach Meßsignalgröße eingeprägten Strom zu verwenden.

Zur Verminderung der Störsignale ist es zweckmäßig, die Leitungsverbindung zwischen Meßwertgeber und Meßumformer so kurz wie möglich zu halten. Deshalb werden üblicherweise solche Meßumformer in unmittelbarer Nähe der Anschlußarmatur von z.B. Thermoelementen montiert. Ideal ist es, den Meßumformer in die Anschlußarmatur selbst einzubauen.

In chemischen Anlagen, besonders der organischen Chemie, besteht häufig Explosionsgefahr.

Die in diesen Bereichen eingesetzten elektrischen Betriebsmittel dürfen daher keine unerwünschten Zündquellen enthalten. Hierüber gibt es eine Reihe entsprechender gesetzlicher Vorschriften (z.B. VDE 0171).

Für den Explosionsschutz elektrischer Betriebsmittel sind verschiedene Schutzarten zugelassen. Für Meßgeräte, wie z.B. Meßumformer hat sich besonders die Schutzart "eigensicher" eingebürgert. Bei dieser Schutzart muß dafür gesorgt werden, daß die in einem Betriebsmittel im explosionsgefährdeten Raum auftretenden Spannungen und Ströme so klein gehalten werden, daß ihre Energie für eine Zündung von explosiven Gasgemischen nicht ausreicht.

Es muß daher dafür gesorgt werden, daß es im Meßumformer im explosionsgefährdeten Bereich nicht zu lokalen Überhitzungen kommen kann, die eine Explosion auslösen würden, wenn sie mit einem zündfähigen Gemisch in Kontakt kämen. Deshalb ist es üblich, solche Meßumformer dicht mit speziellen Vergußmassen zu vergießen.

Eine solche lokale Überhitzung muß aber auch sicher vermieden werden, wenn ein Störungsfall eintritt und z.B. in dem Meßumformer ein teilweiser oder vollständiger Kurzschluß vorliegt. Es ist daher üblich, für diesen Fall als besonders zuverlässig angesehene Strombegrenzungswiderstände in die Vergußmasse mit einzubetten. Im Störungsfall werden in diesen Widerständen jedoch Leistungen umgesetzt, die zu Übertemperaturen am Widerstand führen, die an sich zu einer Zündung ausreichen. Durch die Vergußmasse wird zwar das zündfähige Gemisch vom heißen Widerstand ferngehalten, es muß aber dafür gesorgt werden, daß die Außentemperatur der Vergußmasse an keiner Stelle die Zündgrenze erreicht. Außerdem darf die Vergußmasse an keiner Stelle durch die hohe Übertemperatur des Begrenzungswiderstandes so geschädigt werden, daß z.B. Risse entstehen und das zündfähige Gemisch den heißen Widerstand erreicht. Dies macht besonders bei kleinen Bauformen, bei denen es leicht zu einem Wärmestau kommt, Schwierigkeiten, wie z.B. bei Transmittern, die in Anschußköpfen von Armaturen montiert werden sollen.

Aus der DE—OS 29 37 218 ist eine Vorrichtung zur Vermeidung von lokalen Überhitzungen an mit Strombegrenzungswiderständen versehenen, in Vergußmassen eingebetteten Transmittern bekannt, wobei die Oberflächen der Vermußmassen zur Wärmeableitung mit einer oder mehreren gut wärmeleitenden Begrenzungsflächen versehen werden. Speziell verwendet man hierzu Bleche und Scheiben aus Kupfer oder Aluminium. Diese Vorrichtung hat jedoch den Nachteil, daß für die metallene Oberfläche ein Berührungsschutz erreicht werden muß, was durch Erden geschehen kann. Es müssen daher in vielen Fällen zusätzliche Maßnahmen zur Erdung vorgesehen werden, was zu Problemen bei Hochfrequenzstörstrahlungen führen kann, da das Potential der inneren Schaltung des Meßumformers üblicherweise vom Erdpotential unabhängig sein muß.

Es war daher Aufgabe der vorliegenden Erfindung, eine Vorrichtung zur Vermeidung von lokalen Überhitzungen an mit Strombegrenzungswiderständen versehenen, in Vergußmassen eingebetteten, eigensicheren Meßumformern mit Hilfe von Formkörpern aus einem gut wärmeleitenden Material zu entwickeln, bei der eine zusätzliche Erdung unnötig ist.

Diese Aufgabe wurde erfindungsgemäß dadurch gelöst, daß die Formkörper in der Nähe der Strombegrenzungswiderstände innerhalb der Vergußmasse angeordnet sind.

Besondes vorteilhaft ist es, diese Formkörper, vorzugsweise in Form von Platten oder Hohlzylindern, in unmittelbarer Nähe der Strombegrenzungswiderstände anzuordnen.

Es hat sich überraschenderweise gezeigt, daß man lokale Überhitzungen auf und in der Vergußmasse sicher auch dann verhindern kann, wenn die gut wärmeleitenden Formkörper innerhalb der Vergußmasse angeordnet werden und so keine bzw. nur minimale Kühlungsfunktionen ausüben können. Der Formkörper aus gut wärmeleitenden Material wird dabei so in die Vergußmasse mit eingebettet, daß er an keiner Stelle an die Oberfläche der Vergußmasse tritt. Damit ist der Berührungsschutz automatisch gegeben und eine Erdung nicht erforderlich.

Der Formkörper besteht vorzugsweise aus Metall, wie Kupfer oder Aluminium, kann jedoch auch in gut wärmeleitender Keramik ausgeführt sein, beispielsweise in Berylliumoxid, Aluminiumoxid oder Aluminiumnitrid.

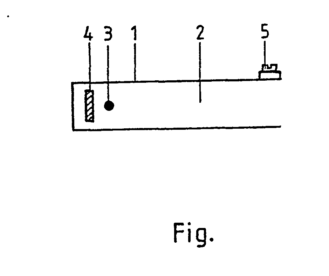

Die Abbildung zeigt schematisch in beispielhafter Ausführungsform einen in Vergußmasse eingebetteten Meßumformer, der mit der erfindungsgemäßen Vorrichtung versehen ist. Innerhalb der Vergußmasse (2) ist hierbei ein Strombegrenzungswiderstand (3) des Meßumformers (1) eingebettet, in dessen Nähe ein Formkörper (4) aus einem gut wärmeleitenden Material angeordnet ist. Die Signale des Meßumformers (1) werden über die Anschlußklemmen (5) abgegeben.

Messungen haben ergeben, daß auch im Störmungsfall keine punktuelle Überhitzung auf der Oberfläche des Meßumformers auftritt, die beim Vorhandensein einer explosiblen Atmosphäre als Zündquelle dienen könnte.

## Patentansprüche

1. Vorrichtung zur Vermeidung von lokalen Überhitzungen an mit Strombegrenzungswiderständen versehenen, in Vergußmassen eingebetteten, eigensicheren Meßumformern mit Hilfe von Formkörpern aus einem gut wärmeleitenden Material, dadurch gekennzeichnet, daß die Formkörper (4) in der Nähe des Strombegrenzungswiderstände (3) innerhalb der Vergußmasse (2) angeordnet sind.

2. Vorrichtung nach Anspruch 1, dadurch gekennzeichnet, daß als Formkörper (4) Platten und Hohlzylinder aus Kupfer und/oder Aluminium eingesetzt werden.

3. Vorrichtung nach Anspruch 1, dadurch gekennzeichnet, daß als Formkörper (4) Platten und Hohlzylinder aus Berylliumoxid und/oder Aluminiumoxid und/oder Aluminiumnitrit eingesetzt werden.

4. Vorrichtung nach Anspruch 1 und 3, dadurch gekennzeichnet, daß die Formkörper (4) in unmittelbarer Nähe der Strombegrenzungswiderstände (3) angeordnet sind.

**Reven**

1. D
locale
intrins
courar
l'aide
bon co
que le
nage o
à l'inte

2. D
risé en
utilise
cuivre

3. D
risé en
utilise
béryllio
d'alum

4. D
caracte
dispos
(3) de

**Claims**

1. A
intrins
rent-lir
compo
of high
the mo
the cui
compo

2. A
in that
or alur

3. A
in that
oxide a
nitrite

4. A
charac
arrang
limiting

juffes
curité
on de
es, à
tériau
en ce
voisiurant,

racté-
4), on
ix en

racté-
4), on
de de
itrure

et 3,
sont
ances

ng at
curotting
iterial
n that
ity of
otting

erized
r and/
).

erized
llium
nium

nd 3,
) are
rrent-

Fig.